# EUROPEAN PATENT SPECIFICATION

(11) **EP 2 850 228 B1**
(45) Date of publication and mention of the grant of the patent: **06.07.2016**
(21) Application number: 13725308.4
(22) Date of filing: 15.05.2013
(51) Int. Cl.: C30B 11/14, C30B 29/06, C30B 11/00, C30B 11/02, B28D 5/04, H01L 31/0312, H01L 31/18, H01L 31/036

(54) **IMPROVED PRODUCTION OF MONO-CRYSTALLINE SILICON**
VERBESSERTE HERSTELLUNG VON MONOKRISTALLINEM SILICIUM
PRODUCTION AMÉLIORÉE DE SILICIUM MONOCRISTALLIN

(30) Priority: 16.05.2012 GB 201208611; 16.05.2012 US 201261647895 P
(43) Date of publication of application: 25.03.2015
(73) Proprietor: REC Solar Pte Ltd., Singapore 637312 (SG)
(72) Inventor: FEFELOV, Oleg, N-3925 Porsgrunn (NO); SAUAR, Erik, N-0372 Oslo (NO); VLADIMIROV, Egor, N-3950 Brevik (NO)
(74) Representative: Gill Jennings & Every LLP
(86) International application number: PCT/EP2013/060105
(87) International publication number: WO 2013/171290

(56) References cited:
- WO-A2-2009/014957
- US-A1- 2011 297 223
- US-B2- 8 048 221
- TAKAHASHI I ET AL: "Generation mechanism of dislocations during directional solidification of multicrystalline silicon using artificially designed seed", JOURNAL OF CRYSTAL GROWTH 20100315 ELSEVIER NLD, vol. 312, no. 7, 15 March 2010 (2010-03-15), pages 897-901, XP002708125, DOI: 10.1016/J.JCRYSGRO.2010.01.011

## Description

### Field of the invention

The present invention relates to the production of crystalline silicon for use in solar cells. In particular, the present invention relates to the production of crystalline silicon by directional solidification processes.

### Background to the Invention

The majority of silicon wafers for use in photovoltaic cells are produced using directional solidification processes such as the Bridgman method. In such processes, solid silicon feedstock is introduced into a crucible and is subsequently melted to form molten silicon. To obtain crystalline silicon, the molten silicon is then gradually solidified in a directional process which allows the crystalline structure to form in a solid silicon ingot.

The silicon formed in conventional directional solidification processes is typically multi-crystalline silicon. As such, the silicon has a complex structure comprising a plurality of crystalline grain formations. The grain boundaries and dislocations that are created during growth or that arise later due to stresses in the material typically lead to a reduced performance. As a consequence, photovoltaic cells formed of mono-crystalline silicon with substantially no disclocations are found to offer better performance than photovoltaic cells formed of multi-crystalline silicon.

The possibility of creating low cost mono-crystalline silicon wafers has therefore been investigated. One process for the formation of mono-crystalline silicon is known as the Czochralski process. In this process, mono-crystalline silicon is formed on an elongated seed crystal which is gradually removed from a crucible of molten silicon while simultaneously being rotated. The result is a cylindrical rod of mono-crystalline silicon. This can then be cut to form wafers for use in photovoltaic cells.

Photovoltaic cells comprising mono-crystalline silicon formed by the Czochralski process can offer improved efficiency as compared to photovoltaic cells formed of multi-crystalline material formed by directional solidification processes. These advantages arise primarily because of the inherent properties of the crystalline silicon, but also because of their suitability for later processing steps. For example, it is common that an etching or texturing step is applied to the surface of a silicon wafer in order to increase its light-absorbing properties.

In particular, a particular wet-etching process has been developed for use with mono-crystalline silicon. In this process, an alkaline solution, such as potassium hydroxide (KOH), is applied to a {100} surface of the mono-crystalline silicon wafer. This results in a surface which comprises a regular array of micro-pyramids. This regular pattern has been found to show good light absorption properties.

The mechanism by which the wet-etching process described above operates is based on the anisotropic effects of the alkaline solution on the wafer. This means that the different crystallographic planes of the wafer are etched at different rates by the solution, resulting in the regular pyramidal surface mentioned above. In order to create this structure, the surface of the wafer must be parallel to the {100} crystallographic plane.

The anisotropic etching process described above does not provide such benefits in the context of a multi-crystalline wafer, which displays no consistency in the orientation of the crystalline structure. As a result, isotropic etching processes are typically applied to multi-crystalline wafers. These tend to create an irregular surface texture, which is less efficient in terms of light absorption than the regular pyramidal structure available with anisotropic etching applied to a {100} crystallographic plane.

So, there are clear benefits to the mono-crystalline wafers produced by the Czochralski process. However, the production of large volumes of wafers for use in photovoltaic cells by this process is found to be relatively expensive as the volume of crystalline silicon that can be produced in a single run of the process is relatively small in practice. In contrast, the crucibles used in directional solidification processes are able to handle a significantly larger amount of silicon in each run.

As a result, multi-crystalline silicon produced by directional solidification processes is substantially cheaper than mono-crystalline silicon produced by the Czochralski process. Furthermore, by using a silicon nitride coating on the inner surface of the crucible during directional solidification processes, the level of oxygen in the crystalline silicon can be reduced in comparison to crystalline silicon formed by the Czochralski process. Oxygen impurities are known be detrimental to the performance of silicon solar cells. There has therefore been an ongoing desire to combine the performance benefits of mono-crystalline silicon with the economic and performance benefits of directional solidification processes.

In recent years, progress in this regard has been made with the use of mono-crystalline seed material in directional solidification processes. In one example of such a technique, a mono-crystalline silicon seed material is placed at the bottom of the crucible before the general silicon feedstock is introduced. The silicon feedstock is then melted before being gradually solidified, starting from the only partially melted mono-crystalline seed material. The mono-crystalline seed material acts as the foundations of the crystalline structure in the silicon ingot. In this way, the silicon ingot that is formed comprises at least one substantially mono-crystalline region. As mentioned above, this produces important performance benefits when the silicon formed in this way is used for its ultimate purpose, such as for photovoltaic cells.

Silicon wafers are formed from horizontal slices through the silicon ingot. To ensure that these present a {100} crystalline surface as required for the anisotropic etching process, the seed material is provided such that the {100} plane is perpendicular to the vertical direction.

Although the use of a seed material in directional solidification processes has been found to offer some success in the growth of mono-crystalline material, it is not completely effective or attractive. In particular, it is found that as the solidification process progresses, the proportion of mono-crystalline silicon formed decreases. In particular, a multi-crystalline region extends from the outer walls of the crucible progressively further towards the centre of the ingot. The result is that the final ingot contains a central mono-crystalline region surrounded by a multi-crystalline region, the area of the multi-crystalline region increasing further up the ingot.

In practice, it is found that the angle between the mono-crystalline region and the seed material, or the bottom of the crucible, frequently is as little as 45-65 degrees. Thus, wafers cut from the ingot contain a significant proportion of multi-crystalline material. This multi-crystalline part of the ingot is inherently less electrically efficient when used for its purpose in photovoltaic cells than the mono-crystalline part of the ingot, and in face has been found to offer worse performance than standard multi-crystalline material. Moreover, the multicrystalline part is inappropriate for the anisotropic etching process described above. As well as limiting the light absorbing efficiency of the wafers and offering a reduced electrical performance, this latter point also leads to a major undesirable visual difference between etched regions in the wafer that are formed of mono-crystalline material and those that are formed of multi-crystalline material. This very visible inhomogeneity means that it is difficult for manufacturers of solar modules to use such wafers in a module, since customers prefer modules which appear homogenous.

Another disadvantage of the incursion of multi-crystalline regions into the ingot comes in the formation of the silicon wafers from the ingot. In particular, it has been proposed to cut the ingot using a wire, and in particular multi-wire sawing technique. The wires used in such techniques may be provided with diamond particles. In the right circumstances, such techniques can provide a high throughput of cut wafers. However, the grain boundaries, defects and dislocations of the multi-crystalline silicon frequently allow impurities such as silicon carbide to become embedded in the ingot. Such impurities not only decrease the efficiency of the material further, but are also relatively hard, and can break the diamond wire during cutting. As a result, the multi-crystalline regions can cause less optimal cutting processes to be required. This problem is particularly acute when forming ingots using a mono-crystalline seed. This is because the increased time necessary in the process to carefully control the melting of the silicon feedstock without fully melting the seed material offers an increased risk of contamination of the molten material by carbon.

Attempts have been made to mitigate the difficulties described above. For example, it has been proposed that the seed material may be provided on the side walls of the crucible as well as on the crucible floor, as described in US patent 8,048,221. This is intended to seed the mono-crystalline structure from the side walls, avoiding the growth of multi-crystalline silicon at the sides of the ingot. However, it is extremely difficult to control a process of this kind. For example, given that, prior to solidification, molten silicon is provided in the crucible all the way down the seed material placed on the crucible floor, it is difficult to ensure that the seed material on the side walls does not melt. Melting of the seed material renders it ineffective since its crystalline structure is lost.

Another approach that has been suggested involves arranging a silicon monocrystalline seed in the bottom area of a crucible and having a seed surface comprising a {110}-crystal orientation and an edge surface having a {100}-crystal orientation, as described in US 2011/0297223. Solidification of liquid ultra-pure silicon starting from the bottom of the crucible forms a silicon block which largely takes over the {110}-crystal orientation.

WO 2009/014957 describes another method whereby a peripheral portion of silicon tiles having a {111} crystallographic seed plane allows monocrystalline or bi-crystalline silicon to be formed that is substantially free of radially-distributed impurities and defects.

Another approach that has been suggested involves managing the temperature distribution within the crucible more closely in an effort to ensure that a higher proportion of crystal growth originates from the seed material. For example, potential control mechanisms might include intensified cooling of the centre of the crucible and exaggerated heating of the side walls of the crucible. However, in practice such processes suffer from numerous disadvantages, such as increased stress in the ingot which will make it more likely to crack and increased frequency of defects such as twin grain boundaries and dislocations. Moreover, the heat added to the side walls of the crucible represents a cost in terms of energy use and is difficult to implement without melting the seed material. Furthermore, implementation of these processes will slow down crystal growth and productivity.

There is therefore an ongoing need to improve methods for the production of crystalline silicon for use in photovoltaic cells. In particular, while current techniques offer either high quality or low cost silicon wafers, there is a desire to improve both these aspects simultaneously.

### Summary of the invention

According to a first aspect of the present invention, there is provided a method for producing crystalline silicon for use in photovoltaic cells, the method comprising: providing a crystalline silicon seed layer in a crucible, wherein a periphery of the silicon seed layer defines a seed layer peripheral surface facing an inner wall of the crucible, the periphery of the seed layer comprising a plurality of peripheral seed tiles; providing silicon feedstock above the seed layer; melting the silicon feedstock and an upper part of the seed layer, thereby creating molten silicon within the crucible; directionally solidifying the molten silicon to form a silicon ingot; wherein each of the peripheral seed tiles is arranged such that it comprises a first {110} crystallographic plane substantially parallel to an adjacent face of the inner wall of the crucible and a second {110} crystallographic plane substantially normal to a direction of solidification of the molten silicon.

According to the present invention, a directional solidification method may be provided to create a silicon ingot of which a substantial proportion has a defined crystalline structure determined by the seed tiles. It is found that by using peripheral seed tiles that that are arranged such that a first {110} crystallographic plane faces an adjacent face of the inner wall of the crucible, and which also have a second {110} crystallographic plane normal to the direction of solidification, the encroachment of multi-crystalline silicon from the walls of the crucible above the seed layer is substantially reduced. The proportion of the ultimate ingot which has a crystalline structure successfully seeded by the seed layer can therefore be increased.

In practice, it will be appreciated that there may be slight variations in the alignment of the first and second {110} crystallographic planes with the inner walls of the crucible and the direction of solidification respectively. Preferably, the first and second {110} crystallographic planes of each peripheral seed tile is aligned to within 15 degrees of each geometric identity. In particular the first {110} crystallographic plane of each peripheral seed tile is preferably aligned to within 15 degrees of parallel to the adjacent face of the inner wall of the crucible. Similarly, the second {110} crystallographic plane may preferably be aligned to within 15 degrees of normal to the direction of solidification.

Preferably, the peripheral surface of the seed layer lies predominantly in a {110} crystallographic plane. As such, over 50% of the seed layer peripheral surface lies in a {110} crystallographic plane of the seed layer. Preferably, at least 60%, 70%, 80%, or 90% of the peripheral surface lies in a {110} crystallographic plane of the seed layer. The greater the proportion of the peripheral surface which is parallel to a {110} crystallographic plane, the greater the region in which the encroachment of multi-crystalline silicon from the inner surface of the crucible is inhibited.

In preferred embodiments, the peripheral surface is formed from a plurality of peripheral seed tiles, and wherein the peripheral seed tiles are arranged in at least two different crystallographic orientations, the at least two crystallographic orientations being related by a rotational transformation around an axis parallel to the direction of solidification of the molten silicon. By providing multiple seed tiles in multiple orientations, an increase in the proportion of the peripheral edge of the seed layer which is in a {110} plane can be increased. In particular preferred embodiments, there are two different crystallographic orientations at 90° relative to one another. This finds particular utility in crucibles having a rectangular or square cross-section.

In some preferred embodiments, peripheral seed tiles having different crystallographic orientations are separated by at least one separation tile. Preferably, the separation tile is a silicon seed tile, and is preferably a silicon seed tile of a monocrystalline structure. The different crystallographic orientation of the separation tile is chosen in such a way that grain boundaries that generate dislocations are not created at the points of contact with of the separation tiles with adjacent seed tiles. For example, it is preferred that small angle grain boundaries should be avoided, although it may also be beneficial to avoid other types of grain boundaries that can create dislocated areas. These may include boundaries such as that created between two pieces of crystalline silicon obtained by 90° rotation around the vertical axis, as may be the case for the peripheral seed tiles. In order to avoid problems arising from such a boundary, the separation tile may comprise a different crystallographic plane normal to the direction of solidification than present in the peripheral tiles. For example, whereas the peripheral tiles have a {110} plane normal to the direction of solidification, the separation tiles may comprise a {100} crystallographic plane normal to the direction of solidification of the molten silicon. This may act to reduce the defects and dislocations that may arise due to the boundary between peripheral seed tiles of differing orientations. While the separation tile introduces a grain boundary where it is adjacent to a peripheral tile, the boundary is well defined and does not lead to defects.

In some preferred embodiments, at least one pair of adjacent seed tiles are arranged such that at least one pair of equivalent crystallographic planes of the adjacent seed tiles are tilted by an angle of between 5 degrees and 15 degrees around a horizontal axis. Preferably, all adjacent seed tiles may be arranged in this manner. It is found that this may also reduce the production of dislocations at the boundaries between seed tiles, instead causing the formation of a defined grain boundary which does not badly affect the electrical properties of the ingot. The angle is preferably greater than 10 degrees.
In preferred embodiments, the seed layer further comprises at least one central seed tile surrounded by the one or more peripheral seed tiles. In some particularly preferred embodiments, at least one central seed tile has a crystallographic orientation normal to the direction of solidification of the molten silicon which is different to that of the one or more peripheral seed tiles. For example, at least one central seed tile may be arranged such that solidification of the molten silicon occurs in a direction normal to a {100} crystallographic plane. This arrangement allows the peripheral seed layers to protect the silicon ingot from the encroachment of multicrystalline silicon from the inner wall of the crucible, while still allowing alternative crystallographic orientations in the silicon ingot.

The seed layer may alternatively or additionally comprise at least one central seed having a crystallographic orientation normal to the direction of solidification of the molten silicon which is the same as that of the one or more peripheral seed tiles. In some embodiments, there is a plurality of central seed tiles, and seed tiles having the same crystallographic orientation normal to the direction of solidification of the molten silicon are separated from one another by seed tiles having a different crystallographic orientation normal to the direction of solidification. Accordingly, seed tiles of a given crystallographic orientation may be separated from each other by seed tiles of another crystallographic orientation. As a result, the boundaries between tiles may represent a change in crystallographic orientation. Although the silicon ingot will consequently incorporate boundaries between regions aligned to the different orientations of the seed tiles, it is found that the effect of such boundaries is significantly less deleterious to the quality of the ingot that the dislocations and defects that are engendered by small angle misalignments between seed tiles of the same crystallographic orientation.

Preferably, the method further comprises one or more silicon wafers from the ingot. In preferred embodiments, the process of forming the silicon wafers comprises a wire cutting process, preferably a diamond wire cutting process. Such processes are efficient and cost-effective when forming the wafers, and find particular utility in the context of the present invention due to the reduced risk of silicon carbide impurities as compared to the prior art based on the <100> crystal orientation. Silicon carbide impurities are relatively hard and can damage the wires used for wire cutting processes or can cause saw marks.

In preferred embodiments, the method comprises applying at etching step to the silicon wafers. The etching step may be either anisotropic or isotropic, but it may be particularly appropriate to use an anisotropic etching process in cases where a substantial proportion (for example, over 40%) of the wafer surface lies in a {100} crystallographic plane. However, depending on module design the reflectance of the cells may not be the overriding priority, in which case the seed design could be chosen for optimization electrical properties of the wafers. It could in such circumstances be that most of the wafer area does not have {100} orientation and in this case isotropic etching could be preferred. Preferably, the isotropic etching process comprises applying an acid to the surface of the silicon, and in preferred embodiments the acid may contain hydrofluoric acid (HF) and/or nitric acid (HNO3). Alternatively, the acid may comprise sulphuric acid (H2SO4). In other preferred embodiments, the etching process may comprise a reactive ion etching process and/or plasma etching process.

As the silicon ingot is formed, a quasi mono-crystalline region is created above the seed layer which follows the crystalline structure pattern of the seed layer, while a multi-crystalline material may be formed adjacent to the crucible walls. In preferred embodiments of the present invention, an average angle between outer edges of the mono-crystalline region which has the same crystalline structure as the seed layer and the seed layer itself is at least 70 degrees, more preferably at least 80 degrees. The inner part of the ingot within these edges can be produced without any highly dislocated areas. This is a significant increase in comparison with prior art techniques in which growth conventionally occurs normal to a {100} crystalline surface of a seed layer and where either the multi-crystalline part penetrates more deeply into the ingot or the average quality of the material is below acceptable limits due to highly dislocated areas.

In typical arrangements, a solid-liquid interface travels vertically upwards during solidification. That is to say, the direction of solidification is vertical. Although there might be slight deviations from the vertical (i.e. the solid-liquid interface may not be perfectly planar) the direction of solidification in this context refers to the predominant or average direction of solidification. Accordingly to ensure that the {110} crystallographic plane of the seed layer is normal to the direction of solidification, this plane is disposed substantially horizontally. Thus, to arrange the seed layer such that solidification of the molten silicon occurs in a direction normal to a {110} crystallographic plane of the seed layer, in preferred embodiments the {110} crystallographic plane is preferably arranged parallel to the crucible floor. In practice, the {110} crystallographic plane of the seed layer may not be perfectly aligned with the crucible floor. However, preferably an angle between the {110} crystallographic plane of the seed layer and a floor of crucible is less than 15 degrees, more preferably less than 10 degrees and most preferably less than 5 degrees. The benefits of the invention are apparent even with such minor deviations from perfect alignment.

Indeed, according to preferred embodiments of the present invention, at least 80%, more preferably 90%, of the silicon ingot formed above the seed layer has a crystalline structure aligned with the crystalline structure of the seed layer. As a result, at least these percentages of the silicon ingot may be formed of mono-crystalline material. The mono-crystalline silicon within the ingot may comprise one or more distinct areas of mono-crystalline silicon. For example, the seed layer may comprise a plurality of seed tiles, in which case a distinct area of mono-crystalline silicon may be grown above each seed tile, each area still sometimes being separated by one or a small set of grain boundaries. However, despite this separation, the overall ingot retains its mono-crystalline (rather than multi-crystalline) nature because the orientation of the crystalline structure is the same in each area.

A proportion of the silicon ingot may not be formed above the seed layer. For example, typically a peripheral region of the silicon ingot adjacent to the crucible walls will comprise multi-crystalline silicon. This is a region that is not formed above the seed layer. For example, a gap may be provided between the crucible walls and the seed layer in a preferred embodiment, and as a result mono-crystalline material does not form in the region above this gap. The gap, and thus the peripheral region, is typically 5-30 mm in width. The gap could be as little as little as 2 mm or even 1 mm is preferably maintained to compensate for thermal expansion differences between the silicon seed layer and the crucible material. The gaps enable cracking of the crucible to be avoided, and consequent silicon run out from the crucible, during the process of crystal formation.

In some embodiments the central part of the seed layer could be formed from seed tiles with the same crystallographic orientation. Similarly, other embodiments may alternatively or additionally comprise central seed tiles that are adjacent to one or more peripheral seed tiles with the same crystallographic orientation. In such circumstances, small angle grain boundaries may be formed due to slight misalignment between adjacent tiles. The mount of dislocations emitted by a small angle grain boundary is proportional to the misalignment angle.

In order to reduce this effect the seed layer may preferably be formed from a single mono-crystalline source. Alternatively, at least those seed tiles which may form a small angle boundary with each other may be formed from a single mono-crystalline source. In particular, the method may comprise forming the mono-crystalline source by a Czochralski process. Using a single source for the seed layer assists in improving the alignment of the seed tiles and consequently reduces the amount of defects generated in the ingot.

According to a second aspect of the present invention, there is provided a silicon wafer formed by the method of the first aspect. There is also provided a photovoltaic cell comprising such as silicon wafer. There is further provided a module comprising the photovoltaic cell. Such a wafer offers good performance in a photovoltaic cell as it will contain a relatively large proportion or even 100% of mono-crystalline silicon.

According to a third aspect of the present invention, there is provided a loaded crucible for use in the production of crystalline silicon by directional solidification, the loaded crucible comprising: a crystalline silicon seed layer wherein a periphery of the silicon seed layer is formed from a plurality of seed tiles defining a seed layer peripheral surface facing an inner wall of the crucible; and each of the peripheral seed tiles is arranged such that it comprises a first {110} crystallographic plane parallel to an adjacent face of the inner wall of the crucible and a second {110} crystallographic plane extending horizontally across the crucible.

### Brief description of the figures

Preferred embodiments of the present invention will now be described with reference to the accompanying figures, in which:
Figure 1 shows a cross section through a crucible and furnace for use with the preferred embodiment of the present invention;
Figure 2A shows a mono-crystalline silicon source obtained using the Czochralski process;
Figure 2B shows the mono-crystalline silicon source of Figure 2A after the after processing to form a cuboid shape;
Figure 2C shows a plurality of mono-crystalline seed tiles formed from the mono-crystalline source of Figures 2A and 2B;
Figure 3 shows a plan view of an arrangement of seed tiles to form a seed layer in accordance with a first preferred embodiment of the present invention;
Figure 4A illustrates the crystallographic structure of a main tile used within the seed layer of Figure 3;
Figure 4B illustrates the crystallographic structure of an edge tile used within the seed layer of Figure 3;
Figure 4C illustrates the tilting of equivalent crystallographic planes in adjacent silicon tiles;
Figure 5A shows a preferred growth direction of crystalline silicon from a seed tile having an upper surface in a {100} crystallographic plane;
Figure 5B shows a preferred growth direction of crystalline silicon from a seed tile having an upper surface in a {110} crystallographic plane;
Figure 6A shows the growth of silicon ingot in accordance with a prior art method;
Figure 6B shows the growth of a silicon ingot in accordance with the method the present invention;
Figure 7 shows the division of a silicon ingot into a plurality of wafers;
Figure 8A shows a silicon wafer formed by a method of the prior art with alkaline texture and anti-reflective coating;
Figure 8B shows a silicon wafer formed by a method according to the present invention with acid texture and anti-reflective coating;
Figure 9 shows a plan view of an arrangement of seed tiles to form a seed layer in accordance with a second preferred embodiment of the present invention;
Figure 10A illustrates the crystallographic structure of a seed tile of a first crystallographic orientation used within the seed layer of Figure 9;
Figure 10B illustrates the crystallographic structure of a seed tile of a second crystallographic orientation used within the seed layer of Figure 9;
Figure 10C illustrates the crystallographic structure of a seed tile of a third crystallographic orientation used within the seed layer of Figure 9;
Figure 11A shows defects and dislocations originating at the junction between two seed tiles with a small angle misalignment;
Figure 11B shows the grain boundary originating at the junction between seed tiles of different crystallographic orientations;
Figure 12 shows a plan view of an arrangement of seed tiles to form a seed layer in accordance with a third preferred embodiment of the present invention; and
Figure 13 illustrates the crystallographic structure of a separation tile used within the seed layer of Figure 12.

### Detailed description

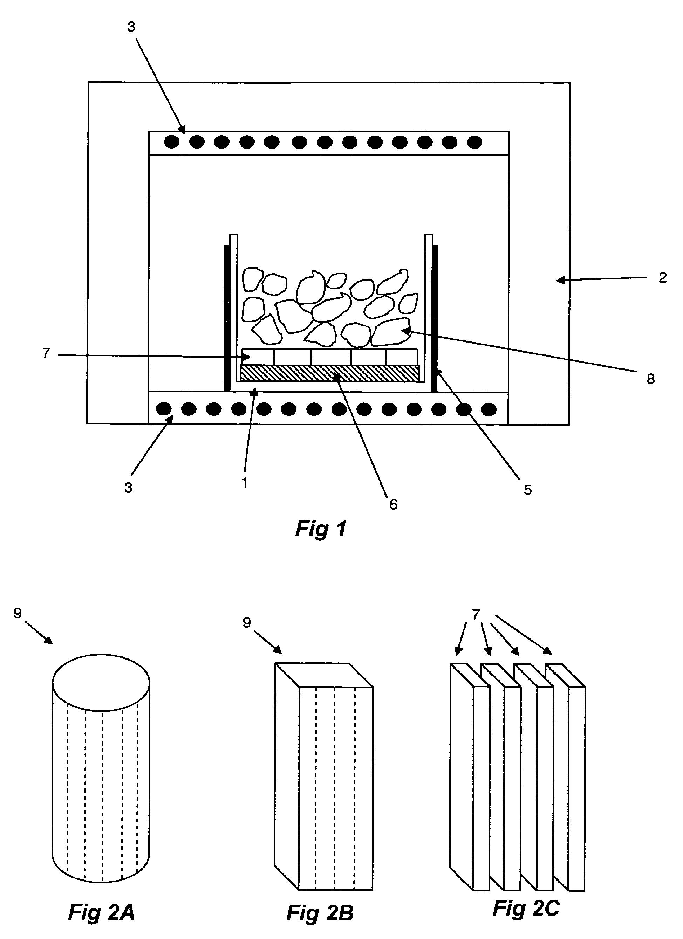

Referring to Figure 1, there is provided a crucible 1 within a furnace hot zone 2. The walls of the furnace hot zone 2 may be formed of graphite or a similar material capable of withstanding high temperatures. In the preferred embodiment, the furnace hot zone 2 shown in Figure 1 is one of a plurality of hot zones within a multi-ingot furnace. Each hot zone 2 may be substantially similar to that shown in Figure 1.

The embodiment of Figure 1 is suitable for use in a directional solidification process for the production of crystalline silicon. Such directional solidification processes include the Bridgman method and Vertical Gradient Freeze methods.

The crucible 1 is preferably formed of silica coated with a coating of silicon nitride. The coating assists in ensuring that solid silicon does not stick to the crucible walls during the crystallisation process and in the removal of crystalline silicon from the crucible after the crystallisation process has been carried out. In order to support the structure of the crucible 1 during the crystallisation process, support plates 5 may be provided adjacent to the crucible. The support plates 5 of the preferred embodiment are formed of graphite or silicon carbide coated graphite. Alternatively, the plates 5 may be formed of another chemically inert material with respect to silicon dioxide, such as silicon nitride.

The preferred embodiment of the present invention further comprises heaters 3 disposed above and below the crucible 1. In the preferred embodiment, the heaters 3 are resistive heaters which dissipate power in the form of heat as an electric current is passed through them. The heaters 3 may be formed of graphite. The heaters 3 should be capable of producing the required temperatures for the production of crystalline silicon, which can be up to 1600 degrees Celsius in the top of the furnace.

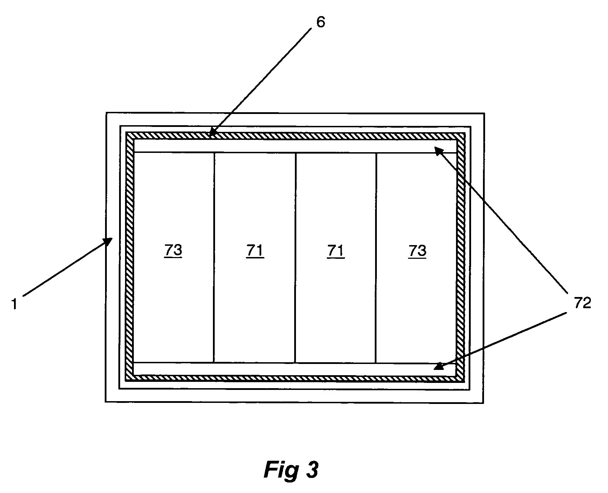

The crucible 1 of the preferred embodiment shown in Figure 1 is loaded with a single silicon slab 6, a seed layer formed of mono-crystalline silicon tiles 7 and silicon feedstock 8. The silicon tiles 7 are placed upon the silicon slab 6, while the silicon feedstock 8 is disposed above the silicon tiles 7. The silicon tiles 7 are arranged such that their upper surface is in a {110} crystallographic plane. As will be explained with reference to Figure 3 below, the silicon tiles comprise main tiles 71 and edge tiles 72, the crystallographic structure of the main tiles 71 and main tiles 72 being rotated around a vertical axis by 90° relative to each other.

The silicon slab 6 is preferably substantially planar, and in the preferred embodiment is substantially planar multi-crystalline silicon. In particular, the silicon slab 6 may be obtained using a directional solidification process which provides a multi-crystalline ingot. The multi-crystalline ingot can then be cut to form the silicon slab 6. A band saw may be used for this cutting step.

The silicon slab 6 may be beneficial in reducing the possibility of small angle misalignment between adjacent silicon tiles 7 of generally the same alignment. However, the silicon slab 6 is not essential, and in particular may not be required when adjacent silicon tiles 7 have different orientations. When a silicon slab 6 is not provided, the silicon tiles 7 may be placed directly on the floor of the crucible 1.

The silicon slab 6 will typically have a thickness of between 1 and 3 cm and will cover substantially but not all of the entire floor of the crucible 1. Alternative thicknesses may be used for the silicon slab 6 if required, such as thicknesses between 0.2 cm and 10cm. In one preferred embodiment, the silicon slab 6 measures approximately 63cm by 63cm, compared to a crucible floor size of 68cm by 68cm.

The silicon slab 6 is preferably slightly smaller than the size of the crucible floor. For example, gaps of at least 0.5cm may be provided between the silicon slab 6 and the walls of the crucible 1. This can allow for shrinkage of the crucible 1 during the production process. Without such gaps, the crucible walls 1 are liable to crack during the production process. Typical gaps between the silicon slab 6 and the crucible walls may be 1 cm or 2cm, but the gaps may be larger if required. Similar gaps are also formed between the silicon tiles 7 and the side walls of the crucible 1.

The silicon slab 6 presents a flat upper surface to receive the seed layer formed of silicon tiles 7. The silicon slab is large enough to support the alignment of all the silicon tiles 7. For example, the area of the silicon tiles 7 may be the same as the area of the silicon slab 6. However, there may also be variations, and the area of the silicon slab 6 may be larger or slightly smaller than that of the silicon tiles 7.

In the preferred embodiment, the silicon tiles 7 are all cut from the same mono-crystalline source 9, and in particular are all cut from a mono-crystalline source 9 created by the Czochralski process. Because the silicon tiles 7 are all cut from the same source, their crystallisation structures can be accurately aligned when they are placed on the silicon slab 6. In particular, each time a different source 9 is formed it is likely that the relative alignment of the crystalline structure and the physical structure will differ slightly. Thus, if silicon tiles 7 are cut from different sources it is difficult to ensure that the crystalline structure within the tiles is fully aligned. It is therefore an advantage that all silicon tiles 7 are formed from the same source 9.

Notwithstanding the above, it may be that an individual source does not offer sufficient material to form a seed layer across the desired proportion of the crucible 1. In such circumstances, it is preferable to form the silicon tiles 7 from as few sources 9 as possible.

An exemplary mono-crystalline source 9 obtained via the Czochralski process is shown in Figure 2A. As can be seen from this Figure, the mono-crystalline source 9 has a cylindrical profile. The tiles 7 are created by cutting along parallel longitudinal planes through the source 9 (such as along the dashed lines in Figure 2A). Typically, this step is preceded by cutting the curved edges from the cylinder to form a wholly or partially cuboid structure, such as that shown in Figure 2B. The cuboid structure is then cut longitudinally to form the tiles 7, as illustrated in Figure 2C.

Figure 3 illustrates a plan view of the silicon tiles 7 upon the silicon slab 6 within the crucible 1. The silicon tiles 7 are provided in two different crystallographic orientations. These are referred to hereinafter as the main tiles 71, 73 which have a first crystallographic orientation and edge tiles 72 which a have a second crystallographic orientation. The main tiles 71, 73 are disposed in a side by side arrangement across the majority of the silicon slab 6 and extend between the edge tiles 72. The edge tiles 72 extend across the ends of the main tiles 71, 73, adjacent to an inner surface of the crucible wall.

The main tiles at the edge of the seed layer are referred to using reference numeral 73 while those disposed away from the edge are referred to by reference numeral 71. The main tiles at the edge 73 together with the edge tiles 72 can be understood as peripheral seed tiles, while the remaining seed tiles 71 are central seed tiles.

The main tiles 71, 73 and edge tiles 72 are arranged such that a {110} crystallographic plane extends horizontally across the crucible 1. As such, the {110} plane is normal to the direction of growth of crystalline silicon during the directional solidification process. That is to say, growth occurs in the <110> direction. In practice, this means that a solid-liquid interface travels in the <110> direction during the process of solidification. This has been found to increase the rate of crystal growth in this direction, which can increase the proportion of crystalline silicon that is formed with a mono-crystalline structure, as will be described in more detail below.

Each of the seed tiles has a rectangular profile in plan view. The main tiles 71, 73 have a rectangular planar profile with length l1 and width w1, where the length l1 is greater than the width w1. Similarly, the edge tiles 72 have a rectangular planar profile with length 12 and width w2, where the length 12 is greater than the width w2. In the preferred embodiment, the length l1 lies in the range 45cm to 65cm, the width w1 lies in the range 45cm to 65cm, the length l2 lies in the range 45cm to 65cm, and the width w2 lies in the range 3cm to 17cm. The height h of the tiles is the same for both main tiles 71, 73 and edge tiles 72, and is in the range of 2cm to 3cm in the preferred embodiment.

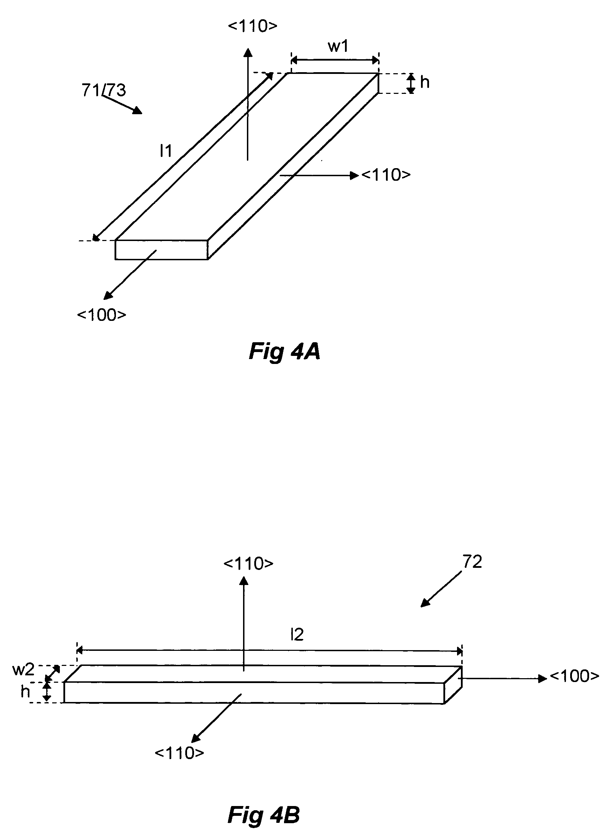

For a rectangular cuboid crystalline silicon tile having an upper surface in a {110} crystallographic plane, one pair of edge surfaces will also lie in a {110} crystallographic plane, while a second pair of edge surfaces lie in a {100} crystallographic plane. This is illustrated in Figure 4A, which illustrates the crystallographic directions normal to the planes of a main tile 71, 73 and Figure 4B, which illustrates the crystallographic directions normal to the planes of an edge tile 72. It can be seen in both Figure 4A and 4B that the edge surface of the tiles that extends along the length of the tile is parallel to a {110} plane, while the edge surface that extends along the width of the tiles is parallel to a {100} plane.

The crystallographic structure of the main tiles 71, 73 placed of the crucible 1 is aligned in all dimensions. However, the crystallographic structure of the edge tiles 72 is rotated 90 degrees around a vertical axis relative to that of the main tiles 71. As a result, the {100} width edges of the main tiles face {110} length edges of the edge tiles. Accordingly, the length edges of both the main tiles 71 and edge tiles 72 that face the inner surface of the crucible 1 are in the {110} crystallographic plane. Only the width edges of the edge tiles 72 present a {100} surface to the inner surface of the crucible 1. In this manner, the seed tiles 7 present a peripheral surface to the inner surface of the crucible 1 which lies predominantly in the {110} plane. As will be described in greater detail below, this is found to offer beneficial effects in terms of the proportion of mono-crystalline silicon that can be grown during a directional solidification process. In some preferred embodiments, a slight tilt angle may be introduced between a pair of equivalent crystallographic planes in the adjacent seed tiles. In particular, equivalent crystallographic planes of adjacent seed tiles may be rotated around a horizontal axis by an angle of between 5 degrees and 15 degrees. It is found that this can reduce the formation of dislocations in the silicon ingot in the region of the boundary between the two seed tiles, instead causing the formation of a defined grain boundary which has less deleterious effects of on the electrical properties of wafers formed from the silicon ingot.

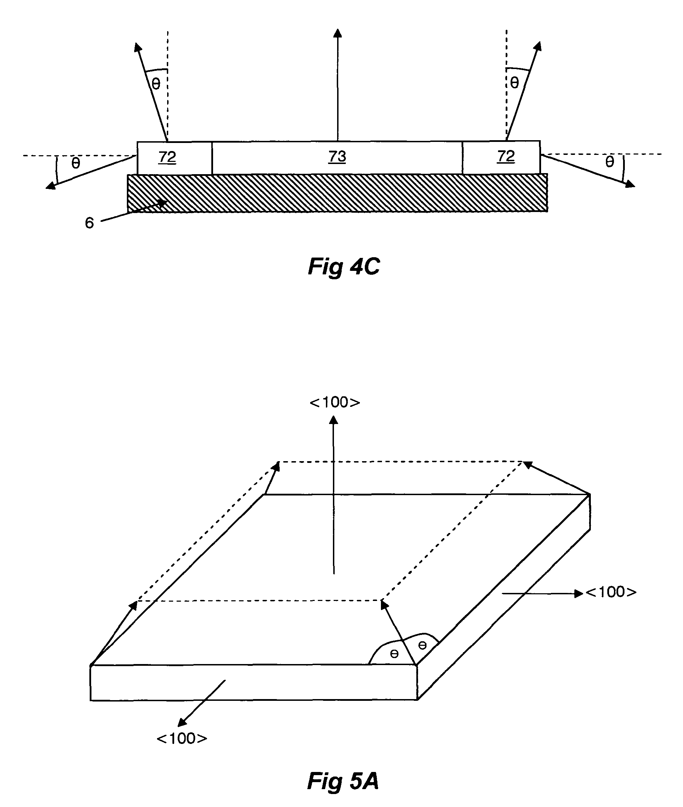

An example of an arrangement of this kind is shown in Figure 4C, which shows a side view illustrating the peripheral seed tiles 72, 73 of the arrangement illustrated in Figure 3 upon the silicon slab 6. In this case, the crystallographic structure of the edge tiles 72 has been slightly rotated around a horizontal axis, such that the {110} crystallographic planes of the edge tiles 72 that are equivalent to the horizontal {110} crystallographic plane of the main tile 73 form an angle of between 5 degrees and 15 degrees with the horizontal. In this case , therefore, the equivalent crystallographic planes are the defined crystallographic planes which are closest to the horizontal. This small angle relative rotation of equivalent crystallographic planes around a horizontal axis can be applied for all adjacent pairs of seed tiles.

Returning to Figure 1, it can be seen that silicon feedstock 8 is provided upon the seed tiles 7. The silicon feedstock 8 of the preferred embodiments comprises a plurality of silicon pieces. These may include silicon chunks obtained through processes such as the Siemens process, recycled silicon chunks from previous directional solidification processes, granular silicon formed through fluidised bed reactor processes, or silicon from any other appropriate source. A mixture of silicon from various sources may be used as appropriate. So, in use, the preferred embodiment of the present invention is operated as follows. Firstly, the crucible 1 is loaded with the silicon slab 6, the silicon tiles 7 and the silicon feedstock 8 and provided in the furnace hot zone 2.

The heaters 3 are activated to begin a melting stage for the contents of the crucible 1. This melting stage comprises heating the hot zone 2 to a suitable temperature. The melting stage is controlled such that melting of the contents starts with those contents at the top of the crucible 1. This means that the first content of the crucible 1 to melt is the silicon feedstock 8. As the melting stage continues, a solid-liquid interface travels downwardly through silicon feedstock 8 towards the silicon tiles 7.

The position and alignment of the silicon tiles 7 relative to each other is further maintained because the silicon slab 6 upon which they are mounted behaves predictably in the high ambient temperatures. In particular, whereas the silica crucible 1 is found to expand in a non-linear manner and different from silicon when heated, any expansion of the silicon slab 6 is substantially matched by that of the silicon tiles 7 in such conditions. As such, the silicon slab 6 provides a platform for the silicon tiles 7 which allow them to retain the closely-packed and aligned formation given to them when loaded into the crucible 1.

The process of melting the content of the crucible 1 is allowed to continue until a small amount of the surface of the silicon tiles 7 has melted, at which point a process of directional solidification begins. It is desired that the amount of silicon tiles 7 that is melted is limited in order to minimize risk of melt-through and to ensure that they can be re-used a maximum number of times in further processes, as will be explained in greater detail below. However, at least a part of the silicon tiles 7 must melt to allow them to act as a seed material during the directional solidification process.

As the silicon tiles 7 of the seed layer are packed closely together with aligned crystalline structure, they act as a mono-crystalline seed during the directional solidification process.

Initiating the directional solidification process comprises controlling the heaters 3 to stop the melting process and to allow the molten material in the crucible 1 to gradually solidify from the seed layer upwards. Typically, the process is initiated by a trained operator who is monitoring the system, but it may be that automatic control of the initiation may be appropriate in some circumstances.

During the directional solidification process, the direction of movement of the solid-liquid interface is reversed as compared to its progress during the earlier melting process. As the solidification occurs, crystalline structure forms in the material, the crystalline structure being aligned with that in the seed layer of silicon tiles 7. As both the main tiles 71 and the edge tiles 72 provide a {110} plane horizontally across the crucible, this alignment is maintained in the silicon ingot. However, it is recognised that the crystalline structure of the edge tiles 72 is rotated relative to that of the main tiles 71, meaning that there is a transition in crystalline structure between regions of the ingot aligned with the main tiles 71 and regions aligned with the edge tiles 72. This boundary extends vertically through the formed ingot, but is relatively controlled and does not provide any noticeable detrimental effect in the electrical performance of photovoltaic cells formed from silicon that crosses the boundary. Moreover, it is found that this approach prevents the encroachment of multi-crystalline silicon into the ingot from the walls of the crucible.

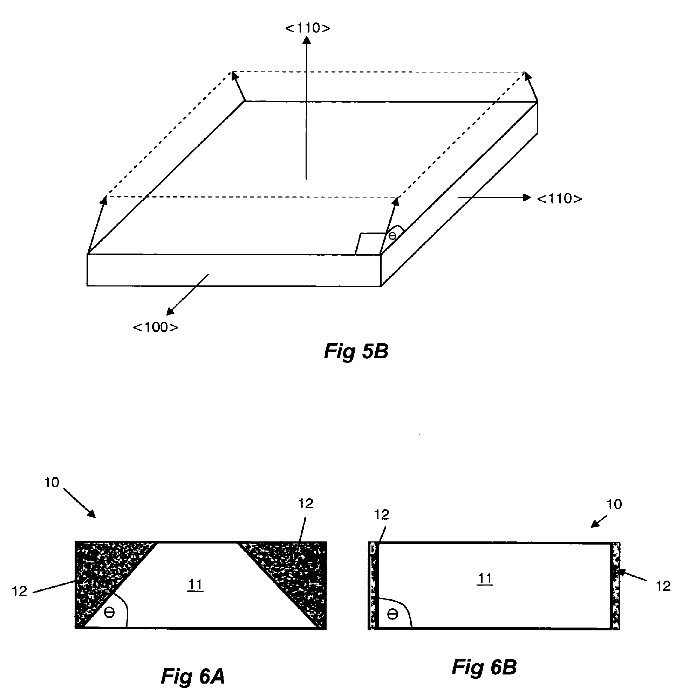

The benefits of the present invention can be understood with reference to Figures 5A and 5B. Figure 5A illustrates a conventional seed tile having surfaces in {100} planes of the crystallographic structure. Crystal growth during directional solidification in a vertical direction has been found to be favoured in directions along {111} planes in the crystallographic structure. As a result, the growth of the crystal tends inwardly from the edge of the seed tile, as illustrated by the arrows provided at each corner of the seed tile. Regions outside of the area defined by these arrows tend to be overcome by the growth of multicrystalline silicon from inner surface of the crucible 1. Thus, as growth continues upwards through the crucible, the area of mono-crystalline silicon that is formed is continually reduced. The acute angle θ represents the angle between the mono-crystalline silicon growth and the horizontal within the crucible 1. This angle may in practice be around 45°.

Figure 5B shows the preferred vertical directional solidification growth of mono-crystalline silicon in which the horizontal plane is parallel to a {110} surface of the crystallographic structure. In contrast to Figure 5A, it can be seen in Figure 5B that this preferred growth does not extend inwardly from the outer edge surfaces of the tile which also lie in a {110} plane. As such, during growth of the crystalline silicon, multi-crystalline silicon is inhibited from encroaching from inner surface of the crucible 1 across the {110} edge of the seed tile. However, encroachment of multi-crystalline silicon from the inner surface of the crucible 1 is still possible across the {100} edge of the seed tile, as the preferred growth direction of the mono-crystalline silicon extends inwardly from this point.

Applying these principles to the arrangement of seed tiles shown in Figure 3, it can be understood that the length edges of the main tiles 71 and main tiles 72 provide the predominant portion of the periphery of the seed layer formed by the seed tiles that is disposed adjacent to the inner surface of the crucible 1. It should be recalled that the length edges arranged to lie {110} crystallographic planes. As a result, during directional solidification, multi-crystalline silicon from the inner surface of the crucible 1 is prevented from encroaching into areas above the main tiles 71. Some encroachment may occur from the width edges of the edge tiles 72, but this is limited in extent by the arrangement of the seed tiles 7.

As a result, a silicon ingot 10 formed substantially or predominantly of mono-crystalline silicon can be formed. For example, the silicon ingot may be formed of at least 80% by volume mono-crystalline silicon of the same crystal orientation, and more preferably at least 95% mono-crystalline silicon of the same crystal orientation. This compares with ingots grown from a {100} plane in the prior art which are typically able to achieve 40% to 70% by volume mono-crystalline silicon. The improvement using the present invention is thus clear. Moreover, it should be born in mind that even where prior art techniques are able to achieve 70% by volume of mono-crystalline silicon, this still implies in practice that approximately 70% of wafers cut from that ingot include a mixture of multi- and mono-crystalline material, as the majority of wafers are typically cut from the edge of the ingot. This mixture of materials in the wafers of the prior art used with an alkaline texture etch limits the performance of the wafers and is highly negative to their visual appearance, both of which have negative effects on their commercial viability.

Following completion of the solidification of the material within the crucible 1, the temperature of the hot zone 2 is gradually reduced until the furnace can be opened and the solidified material is removed from the crucible 1.

Figures 6A and 6B show comparative views of typical silicon ingots 10 formed using seed layers in which growth has occurred normal to the {100} plane (Figure 6A) and normal to the {110} plane (Figure 6B). In each case, the silicon ingot comprises a mono-crystalline region 11 and a multi-crystalline region 12. The boundary of the mono-crystalline region forms an angle with the surface of the seed layer (i.e. with the horizontal) of θ. In the case of a seed layer exhibiting a {100} surface, the angle θ is found to be around 45-65 degrees (Figure 6A) whereas by using a seed layer having a {110} crystallographic surface, the angle θ is substantially 90 degrees (Figure 6B). As a result, the proportion of the mono-crystalline material formed using the {110} seed layer is significantly increased.

Once the silicon ingot 10 is formed, it is removed from the furnace and cut into silicon wafers. Prior to cutting the wafers, edges of the silicon ingot 10 are typically removed to avoid contamination from the crucible walls. Furthermore, a complete bottom section is removed at approximately the same height as the original sum of the heights of the silicon slab 7 and mono seed tiles 7. This bottom section can subsequently be trimmed down in size and reused as a replacement of the original slab 6 and tiles 7.

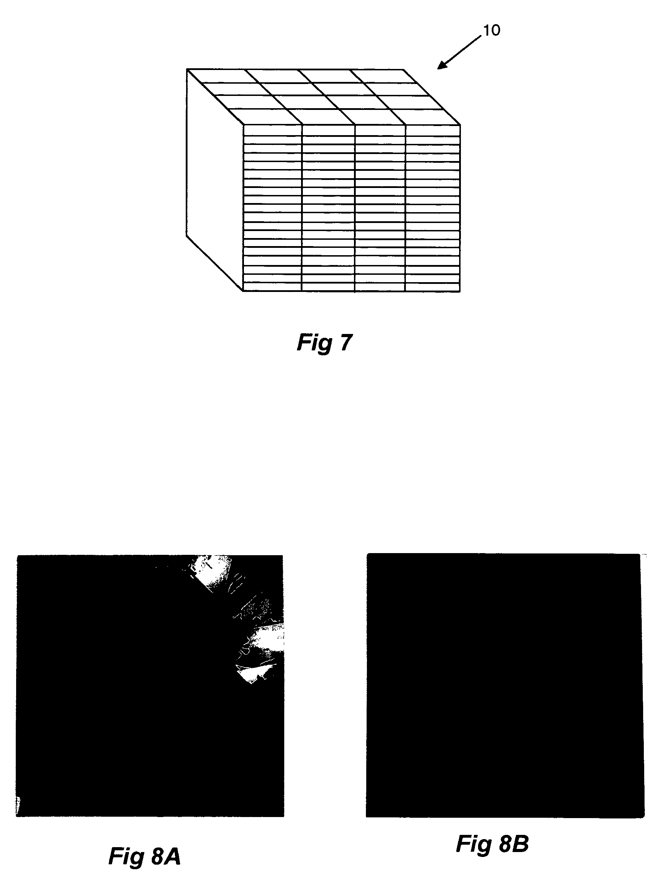

A silicon ingot 10 is illustrated in Figure 7. Figure 7 also shows the lines along which the ingot 10 may be cut to form silicon wafers. As can be seen, the silicon wafers are substantially planar and extend horizontally along the ingot 10. Accordingly, the silicon wafers are cut substantially parallel to the {110} plane. In this manner a significant number of silicon wafers can be cut from a single ingot 10. The wafers are preferably cut using a diamond wire cutting process. In this process, an array of parallel wires is used to saw the silicon ingot into a plurality of wafers. Diamond particles are attached to each wire in the saw and a solvent is typically used to carry silicon and heat away from the silicon ingot. A suitable process is described in international patent application WO 2011/034439, the subject matter of which is incorporated herein by reference. The silicon ingot 10 of the preferred embodiment is particularly susceptible to the wire cutting processes because of the limited amount of multi-crystalline silicon in the ingot. This reduces the potential for impurities in the silicon ingot 10, which are typically introduced at the grain boundaries, defects and dislocations found in multi-crystalline silicon. In turn, this reduces the possibility of damage to the wires in a wire cutting process that can often occur as a result of such impurities, in particular when the wire encounters a relatively hard impurity, such as silicon carbide.

Once cut from the ingot, the wafers are normally washed, dried and inspected by a set of quality measurement tools. Thereafter, the {110} surface of the silicon wafers is etched to increase the surface area and thereby the light absorption efficiency of the wafer. In the preferred embodiment, this etching process is carried out by applying an isotropic etch to the wafers. The isotropic etch may comprise contacting the surface of the wafers with an acid, such as a mixture containing HF and HNO3. Other acids that may be used include H2SO4. In acid-based etching processes, the wafer is introduced to a bath containing the required acid solution, which causes the surface of the wafer to become textures as the acid reacts with the silicon surface. The texture is irregular, but is found to improve light absorption properties of the wafer.

Alternative etching processes may also be used to apply a texture to the surface of the silicon wafer. For example, in alternative embodiments, ion-etching or plasma-etching may be applied. In one example of such a process, nanoimprint lithography and subsequent plasma etching can be used to create a honeycomb structure on the surface of the silicon. An example of such a process is described in the paper by H. Hauser, A. Guttowski, J. Mick, M. Pfeifer, P. Voisin, M. Hermle, et al., published in the Proc. of the 24th European Photovoltaic Solar Energy Conf. and Exhibition, 2009, Hamburg, Germany, the subject matter of which is incorporated herein by reference.

The isotropic etching process provides a consistent response in regions of both mono-crystalline and multi-crystalline silicon. As a result, light absorption characteristics, including the visual appearance of the wafers, are consistent even if some regions of multi-crystalline silicon are present. These advantages can be clearly seen by comparison of Figures 8A and 6B. Figure 8A shows a wafer formed using a {100} seed layer after application of an anisotropic etching process and an anti-reflective coating (these being the two process that determine the visual appearance of the base material). In this case, there is a relatively large region of multi-crystalline silicon which is clearly visible in the ultimate cell. In contrast, Figure 8B shows a silicon wafer which has been formed using a {110} seed layer and subsequently etching the wafer using an isotropic etching process in accordance with the preferred embodiment. Using this technique, not only is the area of any multi-crystalline region significantly reduced but so is the visible distinction between this area and the mono-crystalline part of the wafer.

The above description presents a preferred embodiment of the present invention. However, the skilled person will recognise that various elements may be altered as appropriate. For example, the silicon ingot 10 may be cut across alternative angles in order to form wafers with different crystalline surfaces such as {100}. Moreover, anisotropic etching processes may potentially be used if appropriate.

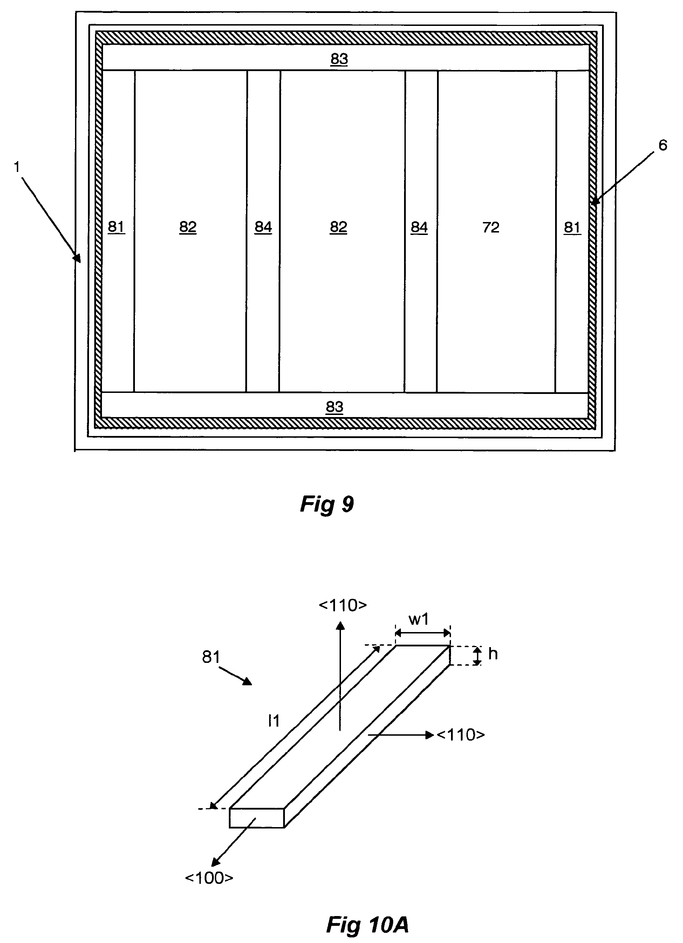

The above embodiment shows a particular arrangement of seed tiles in the seed layer 7. However, it will be understood by the skilled person that alternative arrangements are possible. A second preferred arrangement can be understood with reference to Figures 9 to 13.

Figure 9 illustrates a plan view of the silicon tiles 7 upon the silicon slab 6 within the crucible 1 according to the second preferred embodiment. As can be seen in Figure 9, three types of silicon tiles 7 are provided. These comprise seed tiles of a first crystallographic orientation 81, 84, seed tiles of a second crystallographic orientation 82 and seed tiles of a third crystallographic orientation 83.

Some of the seed tiles of the first crystallographic orientation 81, 84 are disposed at the edge of the seed layer 7 and are indicated by reference numeral 81, while further seed tiles of the first crystallographic orientation are disposed away from the edge of the seed layer 7 are indicated by reference numeral 84. The seed tiles of the first crystallographic orientation 81 at the edge of the seed layer 7 and the seed tiles of a second crystallographic orientation 82 are peripheral seed tiles, while the remaining seed tiles are central seed tiles.

The seed tiles 81, 84, 82 having the first and second crystallographic orientations are disposed alternately along a dimension of the silicon slab 6. Accordingly, each pair of adjacent tiles of a given orientation is separated by a tile of an alternative orientation. Thus, seed tiles of the same orientation are not placed next to one another.

The seed tiles of the first crystallographic orientation 81, 84 and the seed tiles of the second crystallographic orientation 82 are arranged to have different crystallographic planes extending horizontally (i.e. perpendicular to the direction of crystal growth) across the chamber. In the particular embodiment shown in Figure 3, the seed tiles of the first crystallographic orientation 81, 84 are arranged such that a {110} crystallographic plane extends horizontally across the crucible 1, while the seed tiles of the second crystallographic orientation 81 are arranged such that a {100} crystallographic plane extends horizontally across the crucible 1. As such, either the {110} plane or the {100} is normal to the direction of growth of crystalline silicon during the directional solidification process depending on the tiles from which growth originates. That is to say, growth occurs in the <110> direction from the seed tiles of the first crystallographic orientation 81, 84 and in the <100> direction from the seed tiles of the second crystallographic orientation 82. In practice, this means that a solid-liquid interface travels in either the <110> or <100> direction during the process of solidification.

The seed tiles of the third crystallographic orientation 83 comprise a yet further orientation. However, in this case, the seed tiles of the third crystallographic orientation 83 and the seed tiles of the first crystallographic orientation 81, 84 are arranged such that they share equivalent crystallographic planes horizontally across the crucible 1. In the particular embodiment, the seed tiles of the first crystallographic orientation 81, 84 and the seed tiles of the third crystallographic orientation 83 are arranged such that a {110} crystallographic plane extends horizontally across the crucible 1. Growth from both these types of tiles therefore occurs in the <110> direction.

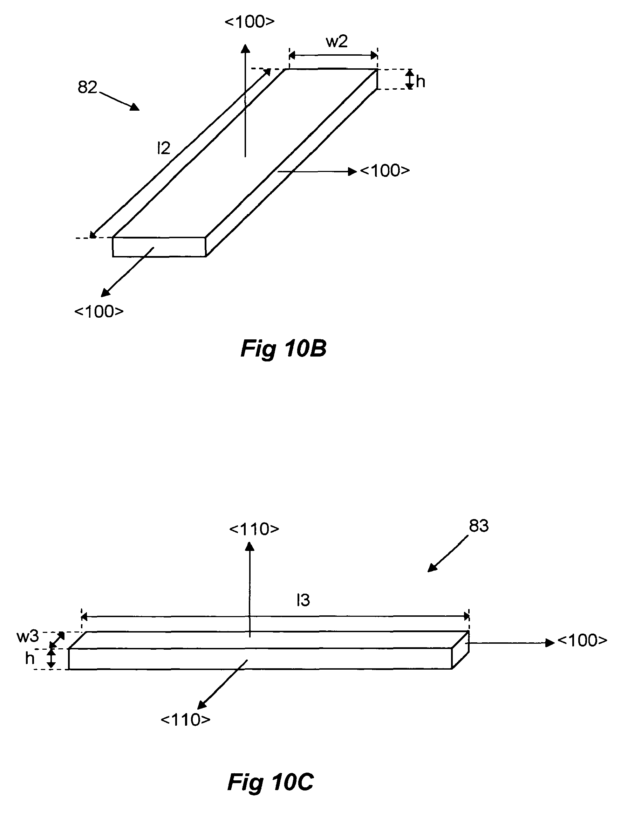

Figure 10A, 10B and 10C respectively illustrate a seed tile of the first crystallographic orientation 81, 84 a seed tile of the second crystallographic orientation 82 and a seed tile of the third crystallographic orientation 83. Each tile has a rectangular cuboid structure, the dimensions of which are illustrated in the Figures together with the crystallographic directions extending normal to the planar surfaces of the tiles.

Each of the seed tiles 7 has a rectangular profile in plan view. The seed tiles of the first crystallographic orientation 81, 84 have a rectangular planar profile with length l1 and width w1, where the length l1 is greater than the width w1. Similarly, the seed tiles of the second crystallographic orientation 82 have a rectangular planar profile with length l2 and width w2, where the length l2 is greater than the width w2. Similarly, the seed tiles of the third crystallographic orientation 83 have a rectangular planar profile with length l3 and width w3, where the length l3 is greater than the width w3. In the preferred embodiment, the lengths l1 and l3 lie in the range 45cm to 65cm, the widths w1 and w3 lie in the range 3cm to 17cm, the length l2 lies in the range 45cm to 65cm, and the width w2 lies in the range 45cm to 65cm. The height h of all tiles is approximately the same, and is in the range of 2cm to 3cm in the preferred embodiment.

For a rectangular cuboid crystalline silicon tile having an upper surface in a {110} crystallographic plane, one pair of edge surfaces will also lie in a {110} crystallographic plane, while a second pair of edge surfaces lie in a {100} crystallographic plane. This can be seen in Figures 8A and 8C, which illustrate the crystallographic directions normal to the planes of a seed tile of the first crystallographic orientation 81, 84 and a seed tile of the third crystallographic orientation 83. In contrast, all surfaces of the seed tiles of the second crystallographic orientation 82 are disposed in {100} crystallographic planes, as illustrated in Figure 8B.

It can be seen in both Figure 10A and 10C that for the seed tiles 81, 83, 84 of the first and third crystallographic orientations the edge surface that extends along the length of the tile lies in a {110} plane, while the edge surface that extends along the width of the tiles lies in a {100} plane.

The crystallographic structure of the seed tiles of the third orientation 83 is rotated 90 degrees around a vertical axis relative to that of the seed tiles of the first orientation 81. As a result, the {100} width edges of the main tiles face {110} length edges of the edge tiles. Accordingly, the length edges of both the seed tiles of the first orientation 81 and the seed tiles of the third orientation 83 that face the inner surface of the crucible 1 are in the {110} crystallographic plane. The seed tile of the first orientation 81, 84 that are adjacent to the walls of the crucible and the seed tiles of the third orientation 83 are peripheral seed tiles which form the peripheral surface of the seed layer 7. Only the width edges of the seed tiles of the third orientation 83 present a {100} surface to the inner surface of the crucible 1. In this manner, the seed tiles 7 present a peripheral surface to the inner surface of the crucible 1 which lies predominantly in the {110} plane. As explained above with reference to Figures 5A to 6B, this is found to offer beneficial effects in terms of the proportion of mono-crystalline silicon that can be grown during a directional solidification process.

The seed tiles 81, 84 of the first crystallographic orientation and the seed tiles of the second crystallographic orientation 82 can be understood as analogous to the main tiles 71, 73 of the first preferred embodiment, while the seed tiles of the third crystallographic orientation 83 can be understood as analogous to the edge tiles 72 of the first preferred embodiment.

As explained above with reference to the first preferred embodiment, during the directional solidification process, the direction of movement of the solid-liquid interface is reversed as compared to its progress during the earlier melting process. As the solidification occurs, crystalline structure forms in the material, the crystalline structure being aligned with that in the seed layer of silicon tiles 7. As both the seed tiles of the first crystalline orientation 81, 84 and the seed tiles of the third crystalline orientation 83 provide a {110} plane horizontally across the crucible, this alignment is maintained in the silicon ingot above these tiles. However, above the seed tiles of a second crystalline orientation 82, a {100} crystallographic plane is provided horizontally across the crucible 1. A grain boundary grows vertically through the ingot to separate regions of {110} horizontal crystallographic plane from regions of a {100} horizontal crystallographic plane.

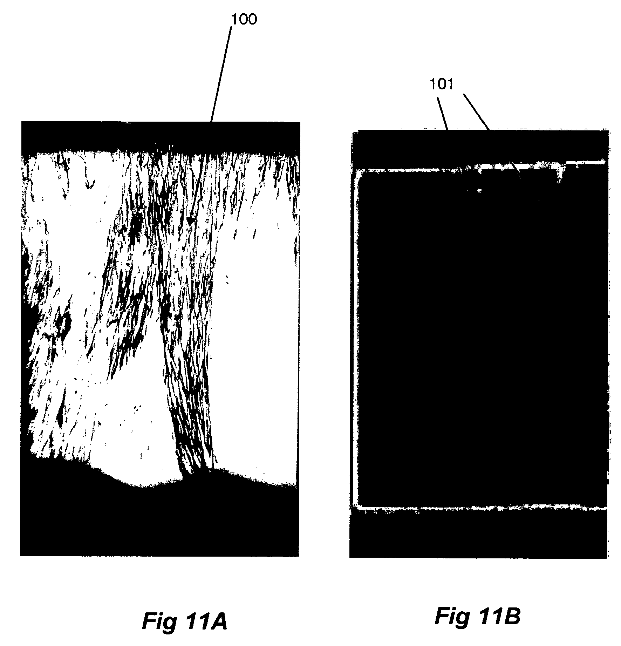

The grain boundary is found not to detrimentally affect the electrical properties of the ingot, particularly in comparison with the defects that arise due to slight misalignments between adjacent tiles of the same crystallographic orientation. This is illustrated in Figures 11 A and 11B.

Figure 11 A illustrates a side view through an ingot that has been formed with seed tiles of identical crystallographic orientation placed side by side in a crucible 1 where a small angle misalignment has occurred. It can be seen that a region 100 of defects and dislocations originates at the boundary between the seed tiles and covers a progressively grater area of the ingot as vertical growth continues. In contrast, Figure 11B shows a SEMILAB image of a block cut from a silicon ingot formed using adjacent tiles of two differing orientations. Grain boundaries 101 can be identified between regions of the ingot above the adjacent seed tiles, but these are constrained locally and do not cause adjacent defects to form.

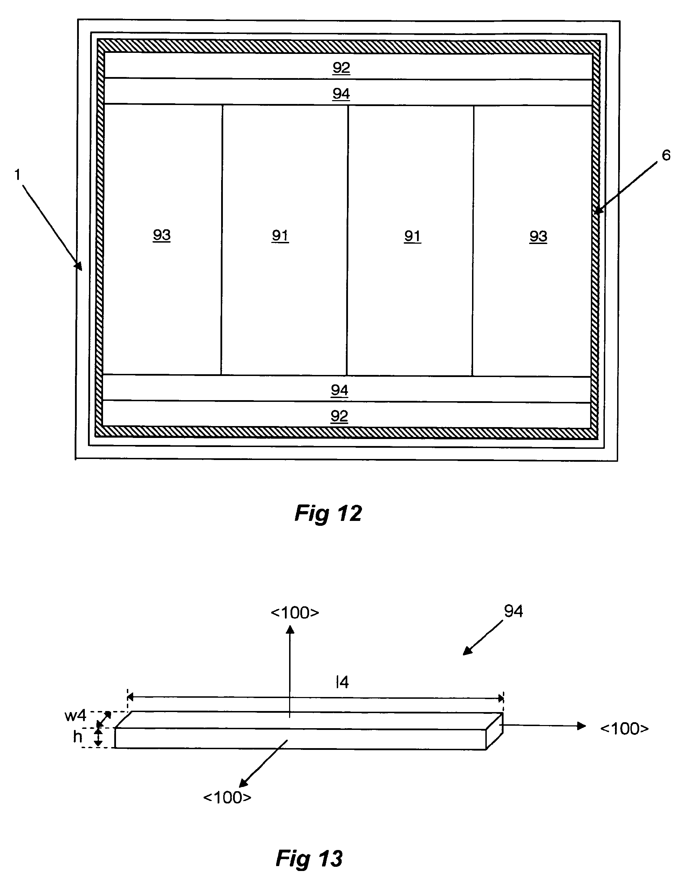

The arrangement of seed tiles according to a third preferred embodiment is shown in Figure 12. This arrangement is similar to the first preferred embodiment, comprising main tiles 91, 93 and edge tiles 92 which arranged identically to those of the first preferred embodiment. However, the third preferred embodiment further comprises separation tiles 94.

The separation tiles 94 have surface which lie in {100} crystallographic planes, as illustrated in Figure 13. The separation tiles separate the edge tiles 92 from the main tiles 91, 93. In particular, while both the main tiles 91, 93 and the edge tiles 92 provide a {110} plane horizontally across the crucible, the separation tiles 94 provide a {100} crystallographic plane horizontally across the crucible 1. As such, during directional solidification, a grain boundary grows vertically through the ingot to separate regions of {110} horizontal crystallographic plane from regions of a {100} horizontal crystallographic plane.

As illustrated above in Figures 11A and 11B, a grain boundary of this type is found not to detrimentally affect the electrical properties of the ingot, particularly in comparison with the defects that arise due to slight misalignments between adjacent tiles of the same horizontal crystallographic orientation. Therefore the separation tiles 94 can be used to reduce the number of such defects in the ingot at the interface between the main tiles 91, 93 and the edge tiles 92.

Other variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable sub-combination.

## Claims

1. A method for producing crystalline silicon for use in photovoltaic cells, the method comprising:
providing a crystalline silicon seed layer in a crucible, wherein a periphery of the silicon seed layer defines a seed layer peripheral surface facing an inner wall of the crucible, the periphery of the seed layer comprising a plurality of peripheral seed tiles;
providing silicon feedstock above the seed layer;
melting the silicon feedstock and an upper part of the seed layer, thereby creating molten silicon within the crucible;
directionally solidifying the molten silicon to form a silicon ingot; wherein
each of the peripheral seed tiles is arranged such that the peripheral seed tile comprises a first {110} crystallographic plane aligned substantially parallel to an adjacent face of the inner wall of the crucible and a second {110} crystallographic plane substantially normal to a direction of solidification of the molten silicon.

2. A method according to claim 1, wherein the first {110} crystallographic plane of each peripheral seed tile is aligned to within 15 degrees of parallel to the adjacent face of the inner wall of the crucible.

3. A method according to claim 1 or claim 2, wherein at least 60% of the seed layer peripheral surface is in a {110} crystallographic plane.

4. A method according to any one of the preceding claims, wherein the peripheral surface is formed from a plurality of peripheral seed tiles, and wherein the peripheral seed tiles are arranged in at least two different crystallographic orientations, the at least two crystallographic orientations being related by a rotational transformation around an axis parallel to the direction of solidification of the molten silicon.

5. A method according to any one of the preceding claims, wherein the seed layer further comprises at least one central seed tile surrounded by the peripheral seed tiles.

6. A method according to claim 5, wherein at least one central seed tile has a crystallographic plane normal to the direction of solidification of the molten silicon which is different to the crystallographic plane normal to the direction of solidification of the peripheral seed tiles.

7. A method according to claim 6, wherein at least one central seed tile is arranged such that solidification of the molten silicon occurs in a direction normal to a {100} crystallographic plane of that tile.

8. A method according to any one of claims 5 to 7, wherein the seed layer comprises a plurality of central seed tiles comprising at least one central seed tile having a crystallographic plane normal to the direction of solidification of the molten silicon which is the same as the crystallographic plane normal to the direction of solidification of the peripheral seed tiles.

9. A method according to ay one of claims 5 to 8, wherein seed tiles having the same crystallographic plane normal to the direction of solidification of the molten silicon are separated from one another by seed tiles having a different crystallographic plane normal to the direction of solidification.

10. A method according to any one of the preceding claims, wherein at least one pair of adjacent seed tiles are arranged such that at least one pair of equivalent crystallographic planes of the adjacent seed tiles are tilted by an angle of between 5 degrees and 15 degrees around a horizontal axis.

11. A method according to any one of the preceding claims, further comprising forming one or more silicon wafers from the silicon ingot.

12. A method according to claim 11, further comprising applying an etching step to a surface of the one or more silicon wafers.

13. A method according to any one of the preceding claims, wherein at least 80% of the silicon ingot formed above the seed layer has a crystalline structure aligned with a crystalline structure of the seed layer.

14. A method according to any one of the preceding claims, wherein the seed layer is formed from a single mono-crystalline source.

15. A loaded crucible for use in the production of crystalline silicon by directional solidification, the loaded crucible comprising: a crystalline silicon seed layer wherein a periphery of the silicon seed layer is formed from a plurality of seed tiles defining a seed layer peripheral surface facing an inner wall of the crucible; and each of the peripheral seed tiles is arranged such that it comprises a first {110} crystallographic plane parallel to an adjacent face of the inner wall of the crucible and a second {110} crystallographic plane extending horizontally across the crucible.

## Patentansprüche

1. Verfahren für die Herstellung von kristallinem Silizium für die Verwendung in photovoltaischen Zellen, wobei das Verfahren Folgendes umfasst:
Bereitstellen einer kristallinen Silizium-Keimschicht in einem Tiegel, wobei eine Peripherie der Silizium-Keimschicht eine periphere Oberfläche der Keimschicht definiert, die einer inneren Wand des Tiegels gegenüberliegt, wobei die Peripherie der Keimschicht eine Vielzahl an peripheren Keimkacheln umfasst;
Bereitstellen von Silizium-Rohstoff über der Keimschicht;
Schmelzen des Silizium-Rohstoffs und eines oberen Teils der Keimschicht, wodurch geschmolzenes Silizium in dem Tiegel erzeugt wird;
gerichtetes Erstarren des geschmolzenen Siliziums, um einen Silizium-Ingot zu bilden; wobei
jede der peripheren Keimkacheln derart angeordnet ist, dass die periphere Keimkachel eine erste kristallographische {1110}-Ebene, die im Wesentlichen parallel zu einer benachbarten Seite der Innenwand des Tiegels ausgeuchtet ist, und eine zweite kristallographische {1110}-Ebene, die im Wesentlichen senkrecht zu einer Richtung der Erstarrung des geschmolzenen Siliziums ist, umfasst.

2. Verfahren nach Anspruch 1, wobei die erste kristallographische {110}-Ebene von jeder peripheren Keimkachel innerhalb von 15 Grad parallel zur benachbarten Seite der Innenwand des Tiegels ausgerichtet ist.

3. Verfahren nach Anspruch 1 oder Anspruch 2, wobei mindestens 60 % der peripheren Oberfläche der Keimschicht in einer kristallographischen {1110}-Ebene liegen.

4. Verfahren nach einem der vorstehenden Ansprüche, wobei die periphere Oberfläche aus einer Vielzahl an peripheren Keimkacheln gebildet wird und wobei die peripheren Keimkacheln in mindestens zwei verschiedenen kristallographischen Ausrichtungen angeordnet sind, wobei die mindestens zwei kristallographischen Ausrichtungen durch eine Rotationsumwandlung um eine Achse parallel zur Richtung der Erstarrung des geschmolzenen Siliziums in Beziehung stehen.

5. Verfahren nach einem der vorstehenden Ansprüche, wobei die Keimschicht weiter mindestens eine zentrale Keimkachel umfasst, die von den peripheren Keimkacheln umgeben ist.

6. Verfahren nach Anspruch 5, wobei mindestens eine zentrale Keimkachel eine kristallographische Ebene senkrecht zur Richtung der Erstarrung des geschmolzenen Siliziums aufweist, die sich von der kristallographischen Ebene senkrecht zur Richtung der Erstarrung der peripheren Keimkacheln unterscheidet.

7. Verfahren nach Anspruch 6, wobei mindestens eine zentrale Keimkachel derart angeordnet ist, dass die Erstarrung des geschmolzenen Siliziums in einer Richtung senkrecht zu einer kristallographischen {100}-Ebene dieser Kachel auftritt.

8. Verfahren nach einem der Ansprüche 5 bis 7, wobei die Keimschicht eine Vielzahl an zentralen Keimkacheln umfasst, die mindestens eine zentrale Keimkachel umfasst, die eine kristallographische Ebene senkrecht zur Richtung der Erstarrung des geschmolzenen Siliziums aufweist, die die gleiche ist wie die kristallographische Ebene senkrecht zur Richtung der Erstarrung der peripheren Keimkacheln.

9. Verfahren nach einem der Ansprüche 5 bis 8, wobei die Keimkacheln, die die gleiche kristallographische Ebene senkrecht zur Richtung der Erstarrung des geschmolzenen Siliziums aufweisen, durch Keimkacheln voneinander getrennt sind, die eine andere kristallographische Ebene senkrecht zur Richtung der Erstarrung aufweisen.

10. Verfahren nach einem der vorstehenden Ansprüche, wobei mindestens ein Paar von benachbarten Keimkacheln derart angeordnet ist, dass mindestens ein Paar von äquivalenten kristallographischen Ebenen der benachbarten Keimkacheln um einen Winkel von zwischen 5 Grad und 15 Grad um eine horizontale Achse geneigt ist.

11. Verfahren nach einem der vorstehenden Ansprüche, das weiter das Bilden von einem oder mehreren Silizium-Wafern aus dem Silizium-Ingot umfasst.

12. Verfahren nach Anspruch 11, das weiter das Anwenden eines Ätzschritts auf einer Oberfläche von dem einen oder den mehreren Silizium-Wafern umfasst.

13. Verfahren nach einem der vorstehenden Ansprüche, wobei mindestens 80 % des Silizium-Ingot, der oberhalb der Keimschicht gebildet wurde, eine kristalline Struktur aufweist, die mit einer kristallinen Struktur der Keimschicht ausgerichtet ist.

14. Verfahren nach einem der vorstehenden Ansprüche, wobei die Keimschicht aus einer einzigen monokristallinen Quelle gebildet wird.

15. Beschickter Tiegel für die Verwendung bei der Herstellung von kristallinem Silizium durch gerichtete Erstarrung, wobei der beschickte Tiegel Folgendes umfasst: eine kristalline Silizium-Keimschicht, wobei eine Peripherie der Silizium-Keimschicht aus einer Vielzahl an Keimkacheln gebildet wird, die eine periphere Oberfläche der Keimschicht definieren, die einer inneren Wand des Tiegels gegenüberliegt; und jede der peripheren Keimkacheln derart angeordnet ist, dass sie eine erste kristallographische {1110}-Ebene parallel zu einer benachbarten Seite der Innenwand des Tiegels und eine zweite kristallographische {1110}-Ebene, die sich horizontal über den Tiegel erstreckt, umfasst.

## Revendications

1. Procédé de production de silicium cristallin destiné à être utilisé dans des cellules photovoltaïques comprenant les étapes consistant à :
fournir une couche d'ensemencement de silicium cristallin dans un creuset, dans lequel une périphérie de la couche d'ensemencement de silicium définit une surface périphérique de la couche d'ensemencement faisant face à une paroi interne du creuset, la périphérie de la couche d'ensemencement comprenant une pluralité de tuiles de semences ;
fournir une charge de silicium au-dessus de la couche d'ensemencement ;
faire fondre la charge de silicium et une partie supérieure de la couche d'ensemencement, en créant de la sorte un silicium fondu à l'intérieur du creuset ;
procéder à une solidification dirigée du silicium fondu pour former un lingot de silicium ; dans lequel
chacune des tuiles de semences périphériques est disposée de telle sorte que la tuile de semences périphérique comprend un premier {110} plan cristallographique aligné substantiellement parallèlement à une face adjacente de la paroi interne du creuset et un second {110} plan cristallographique disposé substantiellement perpendiculairement à un sens de solidification du silicium fondu.

2. Procédé selon la revendication 1, dans lequel le premier {110} plan cristallographique de chaque tuile de semences périphérique est aligné à 15 degrés près dans un plan parallèle à la face adjacente de la paroi interne du creuset.

3. Procédé selon la revendication 1 ou la revendication 2, dans lequel au moins 60 % de la surface périphérique de la couche d'ensemencement est comprise dans un {110} plan cristallographique.

4. Procédé selon l'une quelconque des revendications précédentes, dans lequel la surface périphérique est formée à partir d'une pluralité de tuiles de semences périphériques, et dans lequel les tuiles de semences périphériques sont disposées dans au moins deux orientations cristallographiques différentes, les au moins deux orientations cristallographiques étant liées par une transformation de rotation autour d'un axe parallèle au sens de solidification du silicium fondu.

5. Procédé selon l'une quelconque des revendications précédentes, dans lequel la couche d'ensemencement comprend au moins une tuile de semences centrale entourée par les tuiles de semences périphériques.

6. Procédé selon la revendication 5, dans lequel au moins une tuile de semences centrale présente un plan cristallographique disposé perpendiculairement au sens de solidification du silicium fondu qui est différent du plan cristallographique disposé perpendiculairement au sens de solidification des tuiles de semences périphériques.

7. Procédé selon la revendication 6, dans lequel au moins une tuile de semences centrale est disposée de telle sorte que la solidification du silicium fondu se produit dans un sens perpendiculaire à un {100} plan cristallographique de cette tuile.

8. Procédé selon l'une quelconque des revendications 5 à 7, dans lequel la couche d'ensemencement comprend une pluralité de tuiles de semences centrales comprenant au moins une tuile de semences centrale présentant un plan cristallographique disposé perpendiculairement au sens de solidification du silicium fondu qui est le même que le plan cristallographique disposé perpendiculairement au sens de solidification des tuiles de semences périphériques.

9. Procédé selon l'une quelconque des revendications 5 à 8, dans lequel les tuiles de semences ayant le même plan cristallographique disposé perpendiculairement au sens de solidification du silicium fondu sont séparées les unes des autres par des tuiles de semences présentant un plan cristallographique différent disposé perpendiculairement au sens de solidification.

10. Procédé selon l'une quelconque des revendications précédentes, dans lequel au moins une paire de tuiles de semences adjacentes sont disposées de telle sorte qu'au moins une paire de plans cristallographiques équivalents des tuiles de semences adjacentes est/sont inclinée(s) d'un angle compris entre 5 degrés et 15 degrés autour d'un axe horizontal.

11. Procédé selon l'une quelconque des revendications précédentes, comprenant en outre la formation d'une ou de plusieurs plaquettes de silicium à partir du lingot de silicium.

12. Procédé selon la revendication 11, comprenant en outre l'application d'une étape de gravure à une surface de soit une, soit de plusieurs parmi les plaquettes de silicium.

13. Procédé selon l'une quelconque des revendications précédentes, dans lequel au moins 80 % du lingot de silicium formé au-dessus de la couche d'ensemencement présente une structure cristalline alignée avec une structure cristalline de la couche d'ensemencement.

14. Procédé selon l'une quelconque des revendications précédentes, dans lequel la couche d'ensemencement est formée à partir d'une source monocristalline unique.

15. Creuset chargé pour être utilisé dans la production de silicium cristallin par solidification dirigée, le creuset chargé comprenant : une couche d'ensemencement de silicium cristallin dans laquelle une périphérie de la couche d'ensemencement de silicium est formée à partir d'une pluralité de tuiles de semences définissant une surface périphérique de couche d'ensemencement faisant face à une paroi interne du creuset ; et chacune des tuiles de semences périphérique est disposée de telle sorte qu'elle comprend un premier {110} plan cristallographique aligné substantiellement parallèlement à une face adjacente de la paroi interne du creuset et un second {110} plan cristallographique s'étendant horizontalement de part et d'autre du creuset.
